# EUROPÄISCHE PATENTSCHRIFT

(11) **EP 1 233 518 B1**
(45) Veröffentlichungstag und Bekanntmachung des Hinweises auf die Patenterteilung: **02.05.2007**
(21) Anmeldenummer: 01119581.5
(22) Anmeldetag: 16.08.2001
(51) Int. Cl.: H03K 23/00, G01R 21/00

(54) **Schnittstellenanordnung für elektronische Geräte**
Interface arangement for electronic apparatus
Dispositif d'interface pour appareils électroniques

(30) Priorität: 06.11.2000 DE 10054869
(43) Veröffentlichungstag der Anmeldung: 21.08.2002
(73) Patentinhaber: Landis+Gyr AG, 6301 Zug (CH)
(72) Erfinder: Wasmer, Roland, 6048 Horw (CH); Waser, André, 8840 Einsiedeln (CH)
(74) Vertreter: Lagler, Louis

(56) Entgegenhaltungen:
- PATENT ABSTRACTS OF JAPAN vol. 2000, no. 09, 13. Oktober 2000 (2000-10-13) & JP 2000 184476 A (SEKISUI CHEM CO LTD), 30. Juni 2000 (2000-06-30)

## Beschreibung

Die Erfindung betrifft eine Schnittstellenanordnung für ein elektronisches Gerät, insbesondere für einen Elektrizitätszähler oder ein Zusatzmodul für einen Elektrizitätszähler.

### STAND DER TECHNIK

Für ein elektronisches Geräte, insbesondere einen Elektrizitätszähler oder ein Zusatzmodul für einen Elektrizitätszähler, sind verschiedene Schnittstellen zu externen Kommunikationsgeräten bekannt. Im Fall von Elektrizitätszählern oder Zusatzmodulen hierzu dienen derartige Kommunikationsschnittstellen zur Zählerdatenfernauslesung. Dabei gelangen beispielsweise Impulszähler mit einer Impulsschnittstelle oder Modems mit einer Datenschnittstelle zum Einsatz. Im Hinblick auf eine einheitliche Fertigung und eine vorrausschauenden Lagerhaltung können beide Schnittstellen - die Impulsschnittstelle und die Datenschnittstelle - nebeneinander und voll funktionsfähig innerhalb eines Zählers installiert sein, um allfälligen Kundenwünschen kurzfristig gerecht werden zu können. Hingegen wird üblicherweise lediglich eine dieser genannten Schnittstellen tatsächlich in Betrieb genommen, wobei die jeweils andere Schnittstelle vollkommen ungenutzt im Zähler verbleibt. Dies bedeutet dann, dass eines von den nach aussen geführten beiden Klemmenpaaren - eines für die Impulsschnittstelle und eines für die Datenschnittstelle - während der Lebensdauer des Zählers nie mit einem externen Kommunikationsgerät verbunden wird.

Die Anforderungen an heutige Zähler sind allerdings nicht nur technischer Natur, sie sind zudem stark wirtschaftlich geprägt. Darüber hinaus unterliegen Elektrizitätszähler nationaler Gesetz- bzw. Normengebung, die im internationalen Vergleich recht unterschiedlich sein kann. Ein Aspekt, der in Elektrizitätszählern genormt ist, betrifft die Ausgestaltung einer von aussen zugänglichen Klemmenleiste des Zählers, wobei derartige Klemmenleisten regulär nach der Installation und Inbetriebnahme des Zählers plombierbar verschlossen werden können.

Die genormte Ausgestaltung einer Klemmenleiste schreibt unter anderem die Stromtragefähigkeit von Klemmen und die Isolationsabstände zwischen benachbarten Klemmen vor. Somit sind die Platzverhältnisse einer Klemmenleiste lediglich in vorgegebenem Rahmen wählbar, was bei den steigenden Anforderungen an multifunktionale Zähler die Machbarkeitsgrenzen erreichen lässt. Dies führt zu einem Herstellungskonflikt zwischen dem Bereitstellen von Schnittstellenoptionen für die Kunden und den begrenzten Installationsmöglichkeiten hinsichtlich einer maximal möglichen Anzahl einbaubarer Klemmen in einer normgerechten Klemmenleiste. Das Bereitstellen von Schnittstellenoptionen gewinnt nicht zuletzt im Zuge der Liberalisierung des Energiemarktes weitere Bedeutung, da der spätere Einsatzort mit seinen Installationsvoraussetzungen für den Zähler bei der Bestellung desselben noch nicht bekannt sein kann. Des weiteren spielt die Wirtschaftlichkeit bei der Herstellung des Massenprodukts "Zähler" eine dominante Rolle.

### DARSTELLUNG DER ERFINDUNG

Der Erfindung liegt daher die Aufgabe zugrunde eine Schnittstellenanordnung eines elektronischen Geräts dahingehend weiter zu entwickeln, so dass trotz Bereitstellens von mehr als einer Kommunikationsschnittstelle, der Aufwand für die benötigten und nach aussen geführten Klemmen der Kommunikationsschnittstellen reduziert werden kann.

Gelöst wird diese Aufgabe durch die Merkmale des Anspruchs 1.

Der Kern der Erfindung ist darin zu sehen, dass zwei verschiedene Schnittstellenausgänge einer Mikroprozessoranordnung in einem elektronischen Gerät wahlweise über eine Schalteranordnung mit lediglich einem von aussen zugänglichen Klemmenpaar verbindbar sind. Der Vorteil der Erfindung ist darin zu sehen, dass zwar für den späteren Einsatz des elektronischen Geräts alle Schnittstellenoptionen gewahrt werden können, aber dennoch lediglich diejenige zu einem einzigen Klemmenpaar nach aussen geführt wird, die am Einsatzort tatsächlich Verwendung findet.

Die wesentlichen Vorteile sind sowohl technischer wie auch wirtschaftlicher Natur. So kann beispielsweise die normgerechte Ausführung einer Klemmenleiste mit lediglich einem Klemmenpaar für optional mehrere Kommunikationsschnittstellen preiswerter hergestellt werden, und zudem ist es einfacher an dieser Klemmenleiste den Anforderungen an die Stromtragfähigkeit der Klemmen und die Isolationsfestigkeit zwischen benachbarten Klemmen gerecht zu werden.

Bei einer bevorzugten Ausgestaltung der erfindungsgemässen Schnittstellenanordnung ist vorgesehen, die von einem Mikroprozessor bereitgestellten Impulsschnittstellensignale oder Datenschnittstellensignale hinter der Schalteranordnung über eine Pegelanpassung zu schicken, um die ausgehenden Kommunikationssignale normgerecht anzupassen. Von Vorteil ist dabei ebenfalls, die Kommunikationssignale galvanisch von dem zu beschickenden Klemmenpaar zu trennen.

Darüber hinaus ist die Schalteranordnung und die Pegelanpassung durch eine Steuerleitung unmittelbar mit der Mikroprozessoranordnung verbunden. Mittels dieser Steuerleitung werden die Schaltanordnung und die Pegelanpassung auf den Impulsschnittstellenausgang oder den Datenschnittstellenausgang des Mikroprozessors eingestellt, wobei das Steuersignal für diese Umschaltung ebenfalls von der Mikroprozessoranordnung ausgehen kann.

### KURZE BESCHREIBUNG DER FIGUREN

In der Zeichnung sind Ausführungsbeispiele schematisch und vereinfacht dargestellt.
Es zeigen:
- Fig. 1a,b: eine Schnittstellenanordnung mit zwei Schnittstellenausgängen, die über eine Schalteranordnung einem Klemmenpaar verbunden sind; und
- Fig. 2a,b: eine weitere Ausführungsform der Schnittstellenanordnung.

### WEGE ZUR AUSFÜHRUNG DER ERFINDUNG

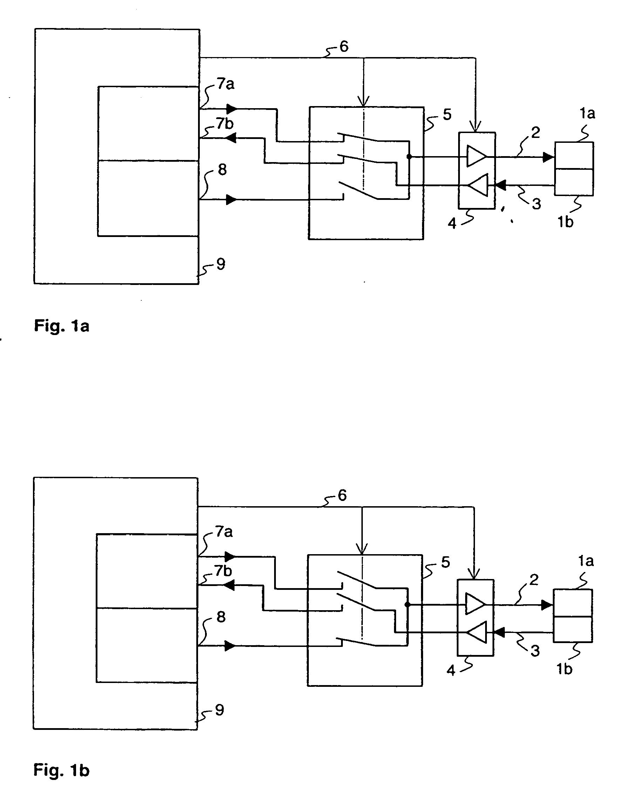

In Fig. 1a ist mit 9 eine Mikroprozessoranordnung eines elektronischen Geräts bezeichnet, die sowohl eine bidirektionale Datenschnittstelle mit den Datenschnittstellenanschlüssen 7a, b als auch einen Impulsschnittstellenausgang mit dem Impulsschnittstellenanschluss 8 umfasst. Mit dieser Mikroprozessoranordnung 9 ist eine Anordnung gemeint, die entweder einen oder mehrere Mikroprozessoren oder einen oder mehrere Controller umfassen kann, die jeweils für sich oder in geeigneter Zusammenschaltung sowohl Datenschnittstellenanschlüsse 7a, b und einen Impulsschnittstellenanschluss 8 umfassen. Des weiteren steht zum Beispiel an den Datenschnittstellenanschlüssen 7a, b eine asynchrone, serielle, bidirektionale Schnittstelle zur Verfügung. Hiermit ist gemeint, dass als Datenschnittstelle jede bekannte Schnittstelle gemeint ist, die für den Austausch von Daten zwischen einem elektronischen Gerät und einer externen Empfangs- und/oder Sendestation geeignet ist. Ähnliches gilt für die Impulsschnittstelle 8, mit der beispielsweise ein zu einer augenblicklich gemessen Leistung proportionales Impulssignal ausgebbar ist.

Die hier angesprochenen Datenschnittstellen und Impulsschnittstellen unterliegen nationalen und internationalen Normen, auf die an dieser Stelle lediglich hingewiesen wird. Genauere Bezeichnungen dieser Normen sind dem einschlägigen Fachpersonal bekannt und bedürfen keiner speziellen Erwähnung. In der hier dargestellten Ausführungsform handelt es sich bei der im Gerät nach aussen geführten Schnittstelle um eine Stromschnittstelle, welche für Datenkommunikation bidirektional und für Impulsweitergabe unidirektional verwendet werden kann.

Die Datenschnittstellenanschlüsse 7a, b und der Impulsschnittstellenanschluss 8 sind mit einer Schalteranordnung 5 verbunden, mit der über zwei Leitungen 2 bzw. 3 entweder diese Datenschnittstellenanschlüsse 7a, b oder dieser Impulsschnittstellenanschluss 8 zu Klemmen 1a, 1b durchgeschaltet werden können. Diese Klemmen 1a, 1b sind ausserhalb des elektronischen Gerätes beschaltbar, und stellen somit den Kommunikationszugang zum elektronischen Gerät dar. Für die Verwendung dieses Klemmenpaares 1a, 1b ist dabei unerheblich, ob diese Klemmen 1a, 1b nach einer Installation und Inbetriebnahme des elektronischen Geräts mittels eines hier nicht dargestellten Klemmendeckels gegen unbefugten Zugriff sicherbar sind oder nicht.

Zwischen der Schalteranordnung 5 und dem Klemmenpaar 1a, 1b ist eine Pegelanpassung 4 angeordnet, und sowohl die Schaltanordnung 5 sowie die Pegelanpassung 4 sind über eine Steuerleitung 6 zusätzlich mit der Mikroprozessoranordnung 9 verbunden.

Wie bereits erwähnt sind über die Schalteranordnung 5 entweder die Datenschnittstellenanschlüsse 7a, b oder der Impulsschnittstellenanschluss 8 der Mikroprozessoranordnung 9 mit dem aussen zugänglichen Klemmenpaar 1a, b verbindbar. In Abhängigkeit von einem Steuerbefehl über die Steuerleitung 6 nimmt die Schalteranordnung 5 zwei verschiedene Schaltpositionen ein. Das über die Steuerleitung 6 gesendete Steuersignal kann über die Mikroprozessorschaltung 9 ausgegeben werden. Optional - wenngleich nicht dargestellt - kann das Steuersignal auch aus einer anderen signalbildenden Anordnung gesandt werden.

Bei der in Fig. 1a gezeigten Schaltposition der Schalteranordnung 5 sind die Datenschnittstellenanschlüsse 7a, b mit dem Klemmenpaar 1a, b verbunden und bei der in Fig. 1b dargestellten Schaltposition der Schalteranordnung 5 ist der Impulsschnittstellenanschluss 8 mit dem Klemmenpaar 1a, b verbunden.

Ebenfalls in Abhängigkeit des über die Steuerleitung 6 gesendeten Steuersignals wird die Pegelanpassung 4 in ihrer Funktion entweder auf den Datenschnittstellenausgang 7a, b oder den Impulsschnittstellenausgang 8a, b eingestellt. Diese Pegelanpassung 4 stellt somit im Zusammenspiel mit dem Datenschnittstellenausgang 7a, b oder dem Impulsschnittstellenausgang 8a, b ein entsprechend normgerechtes Stromsignal oder Spannungssignal bereit.

Besonders vorteilhaft ist die Verwendung der erfindungsgemässen Schnittstellenanordnung in elektronischen Elektrizitätszählern. In diesen Elektrizitätszählern dient beispielsweise eine serielle, bidirektionale Stromschnittstelle als Datenschnittstelle, mit der sämtliche Zählerdaten fernausgelesen werden können. Eine Impulsschnittstelle in einem Elektrizitätszähler gibt die eingezählten Energiequanten in ein Energietotalregister, das hier nicht dargestellt ist, als Stromimpulse an die Klemmen 1a, b weiter.

Da derartige moderne Elektrizitätszähler multifunktionale elektronische Geräte sind, weisen sie an ihren Klemmenleisten eine Vielzahl von Klemmen auf, die hinsichtlich Stromtragefähigkeit und Isolationsabstand Normen unterliegen. Somit findet lediglich eine begrenzte Anzahl Klemmen in einer Klemmenleiste Platz, womit der Wert der vorliegenden Erfindung hier massgeblich zum Tragen kommt. An ein und demselben Klemmenpaar 1a, b kann nun wahlweise eine hinsichtlich Installationsanordnung und Signalpegel normgerechte Datenschnittstelle oder Impulsschnittstelle bereitgestellt werden. In der Regel wird nämlich nur eine dieser Kommunikationsschnittstellen benötigt, so dass ein einziges von aussen zugängliches Klemmenpaar 1a, b völlig ausreicht. Dadurch dass nur ein Klemmenpaar 1a, b notwendig ist können nicht nur der Installationsraum in einer Klemmenleiste reduziert werden, sondern darüber hinaus auch noch Montageaufwand und nicht zuletzt die Kosten. Wirtschaftliche Faktoren spielen bei Zählern bekanntermassen eine bedeutende Rolle, da Zähler im wesentlichen als Massenprodukt hergestellt werden.

Obwohl lediglich ein Klemmenpaar 1a, b zur Kommunikation zur Verfügung stehen, ist erfindungsgemäss der Schnittstellentyp sogar noch am Installationsort des elektronischen Geräts frei wählbar. Dies hat den Vorteil, dass nicht bereits bei der Bestellung die Wahl der Kommunikationsschnittstelle getroffen werden muss. Im Fall von Elektrizitätszählern nimmt die Definition der Kommunikationsschnittstelle schon allein wegen des sich schnell ändernden liberalisierten Strommarktes eine besondere Stellung ein. Zum Zeitpunkt einer Bestellung grosser Stückzahlen von Elektrizitätszählern können oftmals die Bedingungen am späteren Installationsort nicht vollumfänglich ermittelt werden. Deshalb ist mit der erfindungsgemässen Lösung erstmals möglich mehrere Optionen an Kommunikationsschnittstellen bereitzustellen, wobei zudem Installations- und Kostenaufwand sich reduzieren lassen.

Ohne den Erfindungsgedanken zu verlassen, ist ebenfalls denkbar, mehr als die zwei hier beschriebenen Schnittstellenoptionen mittels einer Schalteranordnung auf ein einziges Klemmenpaar zu führen.

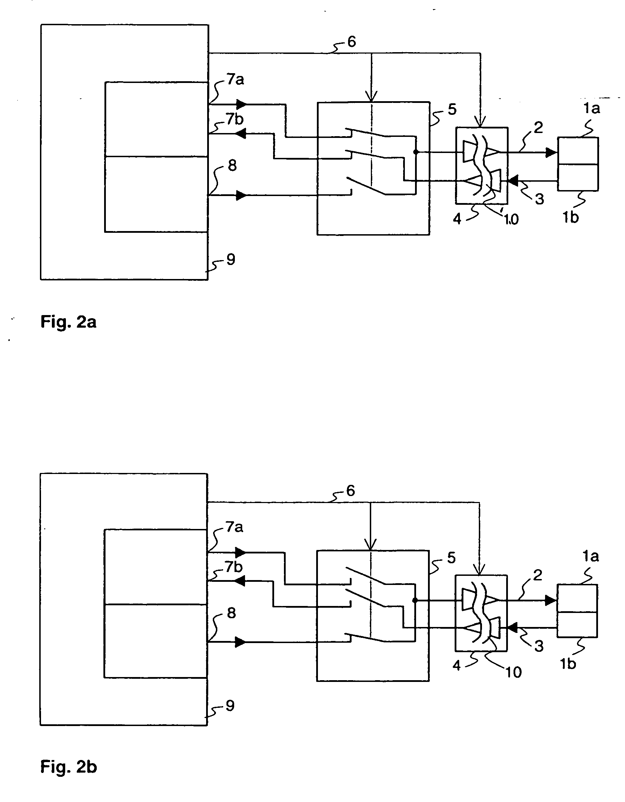

Fig. 2a zeigt die erfindungsgemässe Schnittstellenanordnung, die zusätzlich eine galvanischen Trennung 10 vor dem Klemmenpaar 1a, b umfasst. Dabei ist die Schalteranordnung 5 für das Durchschalten der Datenschnittstellenanschlüsse 7a, b zum Klemmenpaar 1a, b eingestellt. Fig. 2b zeigt entsprechend die erfindungsgemässe Schnittstellenanordnung mit durchgeschaltetem Impulsschnittstellenanschluss 8 zu dem Klemmenpaar 1a, b mit zwischengeschalteter galvanischer Trennung 10.

### BEZUGSZEICHENLISTE

- 1a,b: Klemmenpaar einer Kommunikationsschnittstelle
- 2: Leitung
- 3: Leitung
- 4: Pegelanpassung
- 5: Schalteranordnung
- 6: Steuerleitung
- 7a,b: Datenschnittstellenanschluss
- 8: Impulsschnittstellenanschluss
- 9: Mikroprozessoranordnung
- 10: galvanische Trennung

## Patentansprüche

1. Schnittstellenanordnung für ein elektronisches Gerät, insbesondere für einen Elektrizitätszähler oder ein Zusatzmodul für einen Elektrizitätszähler, umfassend eine Mikroprozessoranordnung (9) mit einem Impulsschnittstellenanschluss (8) und mindestens zwei Datenschnittstellenanschlüssen (7a,b), und ein ausserhalb des elektronischen Geräts zugängliches Klemmenpaar (1 a,b) einer Kommunikationsschnittstelle des elektronischen Geräts, **dadurch gekennzeichnet, dass** wahlweise der Impulsschnittstellenanschluss (8) oder die Datenschnittstellenanschlüsse (7a,b) der Mikroprozessoranordnung (9) über eine Schalteranordnung (5) mit dem Klemmenpaar (1 a,b) der Kommunikationsschnittstelle auf Grund eines Steuerbefehls verbindbar sind.

2. Schnittstellenanordnung nach Anspruch 1, **dadurch gekennzeichnet, dass** zwischen der Schalteranordnung (5) und dem Klemmenpaar (1 a,b) eine Pegelanpassung (4) zur Anpassung an die für die Schnittstellenanordnung geltenden Normen angeordnet ist.

3. Schnittstellenanordnung nach Anspruch 2, **dadurch gekennzeichnet, dass** die Pegelanpassung (4) eine galvanische Trennung umfasst.

4. Schnittstellenanordnung nach Anspruch 2 oder 3, **dadurch gekennzeichnet, dass** die Pegelanpassung (4) über eine Steuerleitung (6) mit der Mikroprozessoranordnung (9) verbindbar ist.

5. Schnittstellenanordnung nach einem der Ansprüche 1 bis 4, **dadurch gekennzeichnet, dass** die Schalteranordnung (5) über eine Steuerleitung (6) mit der Mikroprozessoranordnung (9) verbindbar ist.

## Claims

1. An interface arrangement for an electronic apparatus, in particular for an electricity meter or an auxiliary module for an electricity meter, comprising a microprocessor arrangement (9) with an impulse interface connection (8) and at least two data interface connections (7a, b), and a terminal pair (1a, b) of a communication interface of the electronic apparatus, said terminal pair being accessible outside the electronic apparatus, **characterised in that**, selectively, the impulse interface connection (8) or the data interface connections (7a, b) of the microprocessor arrangement (9) may be connected via a switch arrangement (5) to the terminal pair (1a, b) of the communication interface on account of a control command.

2. An interface arrangement according to claim 1, **characterised in that** a level adaptation circuit (4) for adaptation to the standards which apply to the interface arrangement, is arranged between the switch arrangement (5) and the terminal pair (1a, b).

3. An interface arrangement according to claim 2, **characterised in that** the level adaptation circuit (4) has a galvanic separation.

4. An interface arrangement according to claim 2 or 3, **characterised in that** the level adaptation circuit (4) may be connected to the microprocessor arrangement (9) via a control lead (6).

5. An interface arrangement according to one of the claims 1 to 4, **characterised in that** the switch arrangement (5) may be connected to the microprocessor arrangement (9) via a control lead (6).

## Revendications

1. Dispositif d'interface pour un appareil électronique, en particulier pour un compteur d'électricité ou un module auxiliaire pour un compteur d'électricité, comprenant un dispositif à microprocesseur (9) possédant une connexion d'interface d'impulsions (8) et au moins deux connexions d'interface de données (7a,b), et comprenant une paire de bornes (1a,b) d'une interface de communication de l'appareil électronique, accessible à l'extérieur de l'appareil électronique, **caractérisé en ce que**, au choix, la connexion d'interface d'impulsions (8) ou les connexions d'interface de données (7a,b) du dispositif à microprocesseur (9) peuvent être reliées, sur la base d'une instruction de commande, à la paire de bornes (1a,b) de l'interface de communication par l'intermédiaire d'un dispositif à commutateurs (5).

2. Dispositif d'interface selon la revendication 1, **caractérisé en ce qu'**une adaptation de niveau (4) pour l'adaptation aux normes en vigueur pour le dispositif d'interface est disposée entre le dispositif à commutateurs (5) et la paire de bornes (1a,b).

3. Dispositif d'interface selon la revendication 2, **caractérisé en ce que** l'adaptation de niveau (4) comprend une séparation galvanique.

4. Dispositif d'interface selon la revendication 2 ou 3, **caractérisé en ce que** l'adaptation de niveau (4) peut être reliée au dispositif à microprocesseur (9) par une ligne de commande (6).

5. Dispositif d'interface selon l'une des revendications 1 à 4, **caractérisé en ce que** le dispositif à commutateurs (5) peut être relié au dispositif à microprocesseur (9) par une ligne de commande (6).
